(19) Europäisches Patentamt / European Patent Office / Office européen des brevets

(11) **EP 3 840 065 B1**

(12) **FASCICULE DE BREVET EUROPEEN**

(45) Date de publication et mention de la délivrance du brevet:
**17.07.2024 Bulletin 2024/29**

(21) Numéro de dépôt: **20215515.6**

(22) Date de dépôt: **18.12.2020**

(51) Classification Internationale des Brevets (IPC):
$H01L\ 33/00$ (2010.01)    $H01L\ 33/12$ (2010.01)
$H01L\ 33/32$ (2010.01)    $H01L\ 27/15$ (2006.01)
$H01L\ 21/3063$ (2006.01)   $H01L\ 33/22$ (2010.01)
$H01L\ 33/44$ (2010.01)

(52) Classification Coopérative des Brevets (CPC):
**H01L 33/32; H01L 21/306; H01L 21/30635;**
**H01L 27/153; H01L 33/007; H01L 33/12;**
H01L 21/02203; H01L 27/156; H01L 33/22;
H01L 33/44

(54) **PROCÉDÉ POUR FABRIQUER UNE STRUCTURE GAN/INGAN RELAXÉE ET STRUCTURE EN RÉSULTANT**

VERFAHREN ZUR HERSTELLUNG EINER ENTSPANNTEN GAN/INGAN-STRUKTUR UND DARAUS RESULTIERENDE STRUKTUR

METHOD FOR MANUFACTURING A RELAXED GAN/INGAN STRUCTURE AND RESULTING STRUCTURE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2019 FR 1914962**

(43) Date de publication de la demande:
**23.06.2021 Bulletin 2021/25**

(60) Demande divisionnaire:
**24178820.7**

(73) Titulaire: **Commissariat à l'énergie atomique et aux énergies alternatives
75015 Paris (FR)**

(72) Inventeurs:
• **PERNEL, Carole**
  **38054 Grenoble Cedex 09 (FR)**
• **DUSSAIGNE, Amélie**
  **38054 Grenoble Cedex 09 (FR)**

(74) Mandataire: **Brevalex
Tour Trinity
1 B Place de la Défense
92400 Courbevoie (FR)**

(56) Documents cités:
WO-A1-2019/027820    KR-B1- 101 245 509
US-A1- 2009 001 416   US-A1- 2009 140 274
US-A1- 2013 011 656   US-A1- 2017 237 234

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

## DOMAINE TECHNIQUE

La présente invention se rapporte au domaine général des micro-écrans couleur.

L'invention concerne un procédé pour relaxer une structure GaN/InGaN.

L'invention concerne également une structure GaN/InGaN relaxée.

L'invention trouve des applications dans de nombreux domaines industriels, et notamment dans le domaine des micro-écrans couleur à base de micro-LEDs au pas inférieur à 10 $\mu$m.

## ÉTAT DE LA TECHNIQUE ANTÉRIEURE

Les micro-écrans couleurs comprennent des pixels bleus, verts et rouges (pixels RGB).

Les pixels bleus et verts peuvent être fabriqués à base de matériaux nitrures et les pixels rouges à base de matériaux phosphores. Pour combiner sur le même substrat ces trois types de pixels, la technique dite de « pick and place » est généralement utilisée. Cependant, dans le cas des micro-écrans avec des pixels inférieurs à 10 $\mu$m, cette technique ne peut plus être utilisée à cause, non seulement, des problèmes d'alignement, mais aussi du temps nécessaire pour réaliser une telle technique à cette échelle.

Une autre solution consiste à réaliser la conversion de couleurs avec des boîtes quantiques (QD pour « Quantum Dot » en langue anglaise) ou des nanophosphores. Cependant, le contrôle du dépôt de ces matériaux sur des pixels de faibles dimensions est difficile et leur tenue au flux n'est pas suffisamment robuste.

Il est donc crucial de pouvoir obtenir les trois pixels RGB de façon native avec la même famille de matériaux et sur le même substrat. Pour cela, l'InGaN est le matériau le plus prometteur. Ce matériau peut, en effet, théoriquement couvrir tout le spectre visible en fonction de sa concentration en indium. Les micro-LEDs bleues à base d'InGaN montrent déjà une luminance élevée, bien supérieure à leurs homologues organiques. Pour émettre à des longueurs d'onde dans le vert, les puits quantiques (PQs) de la LED doivent contenir au moins 25% d'indium et pour une émission dans le rouge, il est nécessaire d'avoir au moins 35% d'indium. Malheureusement, la qualité du matériau InGaN au-delà de 20% d'In est dégradée en raison de la faible miscibilité de l'InN dans le GaN, mais aussi en raison de la forte contrainte compressive inhérente à la croissance de la zone active InGaN sur GaN.

Il est donc essentiel de pouvoir réduire la contrainte globale dans les structures à base de GaN/InGaN.

Pour remédier à cette problématique, plusieurs solutions ont été envisagées.

Une première solution consiste à former des nanostructures, comme des nanofils ou des pyramides, pour pouvoir relaxer les contraintes par les bords libres. La croissance des nanofils axiaux peut être réalisée par épitaxie par jets moléculaires (ou MBE pour « Molecular Beam Epitaxy »). En pratique, la faible température de croissance utilisée en croissance par MBE conduit à des faibles rendements quantiques internes (IQE). Les pyramides permettent de courber les dislocations. En particulier, les pyramides complètes ont des plans semi-polaires favorables à l'incorporation d'In et à la réduction du champ électrique interne de la zone active. Pour des pyramides tronquées, les faces tronquées permettent une croissance des puits quantiques sur le plan c, ce qui conduit à une émission plus homogène par rapport à une émission le long des plans semi-polaires d'une pyramide complète. Alternativement, la croissance peut aussi se faire en planaire sur des plans autres que la face c de la structure wurtzite comme la croissance sur les plans semi-polaires qui sont plus favorables à l'incorporation d'In.

Une autre solution consiste à réduire les contraintes dans la zone active de la structure LED en utilisant un substrat ou pseudo-substrat avec un paramètre de maille plus proche du paramètre de maille de l'alliage InGaN des puits quantiques. Ainsi, même avec une configuration planaire, on peut augmenter le taux d'incorporation d'In dans l'InGaN. Il a été montré que, lorsque le paramètre de maille du substrat augmente, le champ électrique interne est réduit par comparaison à une couche contrainte de même concentration en In et les émissions des puits quantiques sont décalées vers le rouge [1]. La couche relaxée d'InGaN obtenue permet de faire croître une hétérostructure III-N par épitaxie en phase vapeur aux organométalliques (ou MOVPE pour « metalorganic vapor phase epitaxy »). Cependant, à ce jour, à notre connaissance, le seul substrat ayant permis cette démonstration est le pseudo-substrat InGaNOS de Soitec obtenu par la technique de Smart Cut™.

Une autre solution pour réduire les contraintes globales dans les structures LEDs à base de GaN/InGaN consiste à porosifier la couche de GaN. Dans la référence [2], on prépare dans un premier temps un empilement comprenant un substrat en saphir recouvert par une couche de GaN non intentionnellement dopée (GaN nid) et une couche de GaN dopée n+. La couche de GaN dopée joue le rôle d'anode et un fil de platine joue le rôle de cathode. La porosification électrochimique est réalisée dans une solution d'acide oxalique (0,2M) en appliquant une tension de 15V pendant 30 min, puis sous rayonnement ultra-violet dans une solution de KOH (0,06M) à 9V pendant 30min. La couche porosifiée de GaN ainsi obtenue permet de faire croître une structure LED à puits quantiques multiples (MQWs pour « multiple quantum wells ») composée d'une couche de GaN n+, cinq puits quantiques (PQ) GaN/InGaN et une couche de contact GaN p. La relaxation importante des contraintes conduit à de meilleures propriétés électriques et optiques, notamment en ce qui concerne la photoluminescence (PL).

La référence [3] divulgue des procédés permettant de former des couches de nitrure de gallium hautement uniformes et fortement poreuses, avec des tailles de pores inférieures à typiquement 100 nm. Une gravure. électrochimique, sous de faibles tensions et dans de l'acide nitrique concentré, du nitrure de gallium fortement dopé type n est utilisée pour former le nitrure de gallium poreux. Les couches poreuses peuvent être utilisées dans des structures réfléchissantes pour des dispositifs optiques intégrés tels que des lasers VCSELs ou encore des LEDs.

La référence [4] divulgue des structures semi-conductrices comprenant chacune une couche électroluminescente, en un nitrure du groupe III (généralement à PO d'InGaN/GaN), disposée entre une région type n et une région type p, et ayant crû sur une région poreuse en un autre nitrure du groupe III (généralement du GaN type n). Une couche de nitrure du groupe III contenant de l'indium est disposée entre la couche électroluminescente et la région poreuse en nitrure du groupe III. Étant donné que la couche de nitrure du groupe III contenant de l'indium est déposée sur la région poreuse, la couche de nitrure du groupe III contenant de l'indium peut être au moins partiellement relaxée, c'est-à-dire que la couche de nitrure du groupe III contenant de l'indium peut avoir une constante de réseau dans le plan supérieure à une constante de réseau dans le plan d'une couche de GaN conventionnellement déposée sur un substrat en saphir.

Cependant, la qualité cristalline de la couche de GaN de la LED dépend du diamètre des pores et de la porosité de la couche de GaN porosifiée, ainsi que de l'épaisseur recherchée. Il est donc nécessaire de trouver les paramètres adéquats à chaque fois, ce qui complique l'industrialisation du procédé.

## EXPOSÉ DE L'INVENTION

Un but de la présente invention est de proposer un procédé remédiant aux inconvénients de l'art antérieur, et permettant d'obtenir une structure GaN/InGaN au moins partiellement voire totalement relaxée, en vue de fabriquer, par exemple, des pixels rouge vert bleu.

Pour cela, la présente invention propose un procédé selon la présente revendication 1, en annexe, pour fabriquer une structure GaN/InGaN au moins partiellement relaxée comprenant les étapes suivantes :

a) fournir un dispositif comprenant :

- une structure GaN/InGaN comprenant une couche électriquement conductrice en GaN dopée recouverte localement par des mésas d'InGaN, les mésas d'InGaN comprenant successivement une couche d'InGaN dopée et une couche d'InGaN non dopée ou faiblement dopée ayant une épaisseur allant de 0,25 à 3 nm,

- une couche électriquement isolante recouvrant la couche électriquement conductrice en GaN dopée entre les mésas,

b) relier électriquement la couche électriquement conductrice en GaN dopée du dispositif et une contre-électrode à un générateur de tension ou de courant,

c) plonger le dispositif et la contre-électrode dans une solution électrolytique,

d) appliquer une tension ou un courant entre la couche électriquement conductrice en GaN dopée et la seconde électrode de manière à porosifier la couche d'InGaN dopée des mésas,

e) former une couche d'InGaN par épitaxie sur les mésas d'InGaN, moyennant quoi on obtient une couche d'InGaN épitaxiée relaxée.

L'invention se distingue fondamentalement de l'art antérieur par la mise en oeuvre d'une étape de porosification sélective de la couche d'InGaN dopée des mésas, par voie électrochimique. La porosification a lieu dans le volume de la couche d'InGaN dopée.

La couche d'InGaN non dopée ou faiblement dopée est électriquement isolante. Elle n'est pas porosifiée lors de l'étape d). Elle peut donc servir de couche de reprise d'épitaxie sur les mésas.

Il est facile d'ajuster les dimensions des pores en fonction du dopage des mésas, de la tension appliquée et/ou de l'électrolyte choisi (nature et/ou concentration) pour atteindre le taux de relaxation désirée, et par la suite la longueur d'onde désirée émise par la zone active (puits quantiques), obtenue par réépitaxie.

La porosification permet d'améliorer l'efficacité d'extraction, en particulier lorsque la taille des pores est comparable avec la longueur d'onde visée.

Cette étape peut être réalisée à faible budget thermique, et notamment à température ambiante (typiquement de l'ordre de 20-25°C), ce qui évite de sublimer le matériau des mésas.

Lors de la reprise d'épitaxie, la température de croissance utilisé (typiquement de 900°C à 1000°C) permet de modifier la couche porosifiée, notamment en élargissant les pores de cette couche, ce qui apporte un degré de liberté supplémentaire tout en conservant le paramètre de maille adapté à la couche ré-épitaxiée.

A l'issue du procédé, on obtient une structure GaN/InGaN au moins partiellement relaxée, voire totalement relaxée.

Selon la présente invention telle que revendiquée, la couche d'InGaN non dopée ou faiblement dopée a une épaisseur de 0,25 à 3nm.

Avantageusement, la couche électriquement isolante est en $SiO_2$ ou en SiN.

Avantageusement, le taux d'indium présent dans les mésas d'InGaN est supérieur ou égal à 8%. Ceci assure une ré-épitaxie de qualité, riche en In.

Avantageusement, les mésas ont une épaisseur inférieure à 100nm. Ainsi, la densité de défauts dans les mésas est limitée malgré la forte concentration en In.

Selon une première variante avantageuse, le dispositif fourni à l'étape a) est fabriqué en formant la couche électriquement isolante puis les mésas d'InGaN.

Selon une autre variante avantageuse, le dispositif fourni à l'étape a) est fabriqué en formant les mésas d'InGaN puis la couche électriquement isolante.

Avantageusement, la couche électriquement conductrice en GaN dopée recouvre un support en saphir ou en silicium.

Avantageusement, le procédé comprend une étape au cours de laquelle on réalise une étape dopage par implantation ou de dopage par épitaxie en phase vapeur aux organométalliques sur les mésas d'InGaN. L'implantation est sélective sur les mésas d'InGaN.

Avantageusement, la couche d'InGaN dopée des mésas a des dopages différents d'une mésa à l'autre. On obtient ainsi des pixels, par exemple trois pixels, ayant des niveaux de dopages différents et donc des pourcentages de relaxation différents, et par suite des longueurs d'onde d'émission différentes. Cette variante de réalisation est avantageuse pour former un dispositif multispectral, par exemple des LEDs de différentes couleurs de façon simplifiée, ou un micro-écran (« microdisplay ») multicouleurs.

Selon un mode de réalisation avantageux, les mésas d'InGaN de la structure fournie à l'étape a) sont obtenues selon les étapes suivantes :

- déposer une couche d'InGaN pleine plaque,
- réaliser localement une étape dopage par implantation ou de dopage par épitaxie en phase vapeur aux organométalliques dans la couche d'InGaN pleine plaque de manière à avoir des zones dopées et des zones non dopées,
- déposer une couche d'InGaN non intentionnellement dopée ou faiblement dopée pleine plaque sur la couche d'InGaN pleine plaque,
- graver la couche d'InGaN pleine plaque à travers la couche d'InGaN non dopée ou faiblement dopée pleine plaque de manière à retirer les zones non dopées, moyennant quoi on forme localement des mésas d'InGaN comprenant une couche d'InGaN dopée et une couche d'InGaN non dopée ou faiblement dopée.

Avantageusement, les zones dopées ont des dopages différents, moyennant quoi la couche d'InGaN dopée des mésas a des dopages différents d'une mésa à l'autre.

Ce procédé présente de nombreux avantages :

- il est simple à mettre en oeuvre,
- il peut être utilisé pour des mésas de faibles épaisseurs (typiquement inférieures à 100nm),
- la structuration en mésa apporte l'effet de compliance,
- il conduit à une relaxation partielle ou totale des contraintes et diminue la polarisation piézo-électrique par comparaison à une couche contrainte de même concentration en In,

- il permet une approche dite « bottom up » pour la fabrication de μLED et μdisplay : la croissance des structures optiques (N, PQ, P) est réalisée après pixélisation en mésa, quel que soit la taille des pixels, et permet de s'affranchir des problèmes d'alignement comme pour le procédé « pick and place »,
- il n'y a pas d'impact du procédé de gravure des pixels sur l'efficacité des micro-LEDs, ce qui rend possible la réalisation de pixel micrométrique ou sub-micrométrique.

L'invention concerne également une structure GaN/InGaN selon la présente revendication 11, en annexe, comprenant successivement :

- une couche électriquement conductrice en GaN dopée,
- des mésas d'InGaN comprenant sucessivement une couche d'InGaN dopée poreuse et une couche d'InGaN non dopée ou faiblement dopée ayant une épaisseur allant de 0,25nm à 3nm,
- une couche d'InGaN épitaxiée et relaxée.

Avantageusement, la couche d'InGaN non dopée, ou faiblement dopée, a une épaisseur allant de 2nm à 3nm. Cette couche est non poreuse.

Par couche poreuse, on entend une couche dont la porosité est supérieure à 1%. De préférence, elle va de 5% à 70%. La valeur de la limite haute est la porosité maximale avant le début de la délamination des mésas.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet; l'objet de la présente invention étant défini par les revendications en annexe.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

Les figures 1A et 1B représentent, de manière schématique, en coupe, un dispositif comprenant une structure GaN/InGaN selon différents modes de réalisation particulier de l'invention.

Les figures 2A, 2B, 2C et 2D représentent, de manière schématique, différentes étapes du procédé de fabrication du dispositif comprenant une structure GaN/InGaN, selon un mode de réalisation particulier de l'invention.

Les figures 3A, 3B et 3C représentent de manière schématique différentes étapes du procédé de fabrication du dispositif comprenant une structure GaN/InGaN, selon un autre mode de réalisation particulier de l'invention.

La figure 4 représente de manière schématique une étape d'anodisation électrochimique de mésas d'InGaN, selon un mode de réalisation particulier de l'invention.

La figure 5 est un graphique représentant différents phénomènes intervenant (pré-porosification (ou « pre-breakdown »), porosification, et électropolissage) lors d'une étape d'anodisation, en fonction du taux de dopage et du potentiel appliqué, selon un mode de réalisation particulier de l'invention.

Les figures 6A et 6B représentent de manière schématique une reprise d'épitaxie sur des mésas d'InGaN, selon différents modes de réalisation particulier de l'invention.

Les figures 7A, 7B, 7C et 7D sont des clichés obtenus au microscope à force atomique (AFM) d'une couche d'InGaN 0.8% avant porosification, après porosification, après porosification et recuit, et finalement après une reprise d'épitaxie, respectivement.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles, tant qu'elles demeurent couvertes par l'étendue des présentes revendications en annexe.

En outre, dans la description ci-après, des termes qui dépendent de l'orientation, tels que « sur », « dessus », «dessous », etc. d'une structure s'appliquent en considérant que la structure est orientée de la façon illustrée sur les figures.

## EXPOSÉ DÉTAILLÉ DE MODES DE RÉALISATION PARTICULIERS

Bien que cela ne soit aucunement limitatif, l'invention trouve particulièrement des applications dans le domaine des micro-écrans couleurs, et plus particulièrement pour la fabrication des pixels rouge vert bleu. Cependant, elle pourrait être utilisée dans le domaine du photovoltaïque ou encore de l'électrolyse de l'eau (« water splitting ») puisque, d'une part, l'InGaN absorbe dans tout le spectre visible et que, d'autre part, ses bandes de valence et de conduction sont autour du domaine de stabilité de l'eau, condition thermodynamique nécessaire à la réaction de décomposition de l'eau. L'invention peut également être intéressante pour la fabrication de LED ou de laser émettant à grande longueur d'onde.

Le procédé, permettant d'obtenir une structure GaN/InGaN partiellement ou totalement relaxée consiste à porosifier l'InGaN par anodisation électrochimique selon les étapes suivantes :

a) fournir un dispositif comprenant :

- une structure GaN/InGaN comprenant une couche électriquement conductrice en GaN dopée 204 recouverte localement par des mésas d'InGaN 100, les mésas d'InGaN 100 comprenant une couche d'InGaN dopée 101 et une couche d'InGaN non dopée ou faiblement dopée 102,
- une couche électriquement isolante 300 recouvrant la couche électriquement conductrice en GaN dopée 204 entre les mésas 100,

b) relier électriquement la couche électriquement conductrice en GaN dopée 204 du dispositif et une contre-électrode 500 à un générateur de tension ou de courant,

c) plonger le dispositif et la contre-électrode 500 dans une solution électrolytique,

d) appliquer une tension ou un courant entre la couche électriquement conductrice en GaN dopée 204 et la seconde électrode 500 de manière à porosifier la couche d'InGaN dopée 101 des mésas 100,

e) réaliser une épitaxie sur les mésas d'InGaN 100, moyennant quoi on obtient une couche d'InGaN épitaxiée au moins partiellement relaxée, et de préférence totalement relaxée.

Le pourcentage de relaxation correspond à :

$$\Delta a/a = (a_{c2} - a_{c1})/a_{c1}$$

avec $a_{c1}$, le paramètre de maille de la couche de départ, et
$a_{c2}$ le paramètre de maille de la couche relaxée,

La couche est relaxée à 100% si $a_{c2}$ correspond au paramètre de maille du matériau massif.

Lorsque $a_{c1} = a_{c2}$ le couche est dite contrainte.

Par partiellement relaxée, on entend un pourcentage de relaxation supérieur à 50%.

Le dispositif fourni à l'étape a) comprend une structure GaN/InGaN. Plus particulièrement, le dispositif comprend un empilement 200 dont la couche supérieure est une couche électriquement conductrice en GaN dopée 204, cette couche étant recouverte et en contact avec des mésas 100 d'InGaN.

Avantageusement, l'empilement de couches 200 recouvert par les mésas 100 d'InGaN comprend :

- une couche support 201, ou support, par exemple en saphir ou en silicium,
- une première couche 202, de préférence en nitrure de gallium (GaN) non intentionnellement dopée (GaN nid) et/ou une deuxième couche 203, de préférence en GaN dopée (GaN n),

- une troisième couche correspondant à la couche électriquement conductrice en GaN dopée 204, cette couche étant, de préférence, fortement dopée (GaN n++).

Par GaN non intentionnellement dopée, on entend une concentration inférieure à $5.10^{17}$ at/cm$^3$.

Par GaN dopée, on entend une concentration supérieure à $10^{18}$ at/cm$^3$.

Par GaN fortement dopée, on entend une concentration supérieure à $10^{19}$ at/cm$^3$.

De préférence, l'empilement 200 est constitué des couches précédemment citées. Autrement dit, il ne comporte pas d'autres couches.

La couche support 201 a, par exemple, une épaisseur allant de $350\mu m$ à 2mm. L'épaisseur dépend de la nature de la couche support 201 et de ses dimensions. Par exemple, pour un support en saphir de 2 pouces (50,8 mm) de diamètre, l'épaisseur est de 350 $\mu m$ et pour un support en saphir de 6 pouces (152,4 mm) de diamètre, l'épaisseur est de 1,3mm.

La première couche 202 a, par exemple, une épaisseur allant de 500nm à $5\mu m$. Cette couche en NID doit absorber les contraintes liées au désaccord de maille entre le GaN et le substrat. Généralement son épaisseur est entre 1 et 4 $\mu m$.

La deuxième couche 203 a, par exemple, une épaisseur allant de 100nm à $1\mu m$ : elle est présente pour assurer la qualité du matériau de la couche supérieure 204.

La troisième couche 204 a, par exemple, une épaisseur allant de 100nm à 500nm. Elle doit être suffisamment conductrice, l'épaisseur minimale varie en fonction du taux de dopage.

La troisième couche 204 électriquement conductrice de l'empilement 200 est directement en contact avec les mésas 100 à porosifier. Lors de l'étape d'anodisation électrochimique la couche électriquement conductrice 204 de l'empilement 200 permet de réaliser une reprise de contact sur l'empilement 200. Cette couche électriquement conductrice 204 est électriquement connectée au générateur de tension ou de courant.

Les mésas 100, aussi appelées élévations, sont des éléments en relief. Elles sont obtenues, par exemple, par gravure d'une couche continue ou de plusieurs couches continues superposées, de manière à ne laisser subsister qu'un certain nombre de "reliefs" de cette couche ou de ces couches. La gravure est généralement une gravure plasma (ou gravure sèche). Les reliefs permettent de définir des pixels.

De préférence, les flancs des mésas 100 sont perpendiculaires à cet empilement de couches 200.

Les dimensions (largeur et longueur) des mésas 100 vont de 500nm à $500\mu m$. Par largeur et longueur, on entend les dimensions parallèles à la surface de l'empilement sous-jacent.

L'espacement (« pitch ») entre deux mésas 100 consécutives va de 50nm à $20\mu m$.

Les mésas 100 d'InGaN comprennent une couche d'InGaN dopée 101 et une couche d'InGaN non dopée ou faiblement dopée 102.

De préférence, les mésas sont constituées de ces deux couches 101, 102.

Par InGaN dopée, on entend une concentration de dopage supérieure à $10^{18}$ at/cm$^3$, voire supérieure à $10^{19}$ at/cm$^3$ pour une couche dite fortement dopée. Le dopage sera choisi en fonction de la technique de porosification (avec ou sans illumination). La couche d'InGaN dopée 101 est électriquement conductrice. Elle est porosifiée lors de l'étape d).

Par InGaN faiblement dopée, on entend une concentration de dopage inférieure à $5. 10^{17}$ at/cm$^3$. Le dopage est suffisamment faible de manière à ce que cette couche soit électriquement isolante. Ainsi la couche 102 n'est pas anodisée, et donc n'est pas porosifiée lors de l'étape d).

La couche dopée 101 des mésas 100 a, avantageusement, une épaisseur allant de 10 nm à 100nm, de préférence de l'ordre de 30nm. Une couche de faible épaisseur (inférieure à 100nm) peut contenir une concentration en In élevée tout en conservant une bonne qualité matériau (peu de défaut). Par épaisseur, on entend la dimension de la mésa perpendiculaire à l'empilement sous-jacent.

La couche d'InGaN non dopée ou faiblement dopée 102 a, par exemple, une épaisseur allant de 1nm à 3nm. Cette couche doit assurer une interface continue pour assurer une reprise d'épitaxie coalescée. On la choisit avantageusement fine, c'est-à-dire, dans le cadre de la présente invention telle que revendiquée, entre 0,25nm et 3nm pour qu'elle soit sans défaut et qu'elle puisse se relaxer grâce au procédé ultérieur de porosification de la couche inférieure 101 et à la reprise d'épitaxie sur les mésas.

La couche électriquement conductrice 204 est recouverte, entre les mésas 100, par une couche électriquement isolante 300 afin de ne pas être en contact avec la solution électrolytique lors de l'étape de porosification et ainsi pour ne pas être porosifiée.

La couche électriquement isolante 300 peut être en oxyde ou en nitrure. De préférence, on choisira un oxyde de silicium ou un nitrure de silicium. Elle a, par exemple, une épaisseur allant de 5nm à 100nm. Pour un nitrure ou oxyde stoechiométrique on choisira une épaisseur inférieure ou égale à 30 nm.

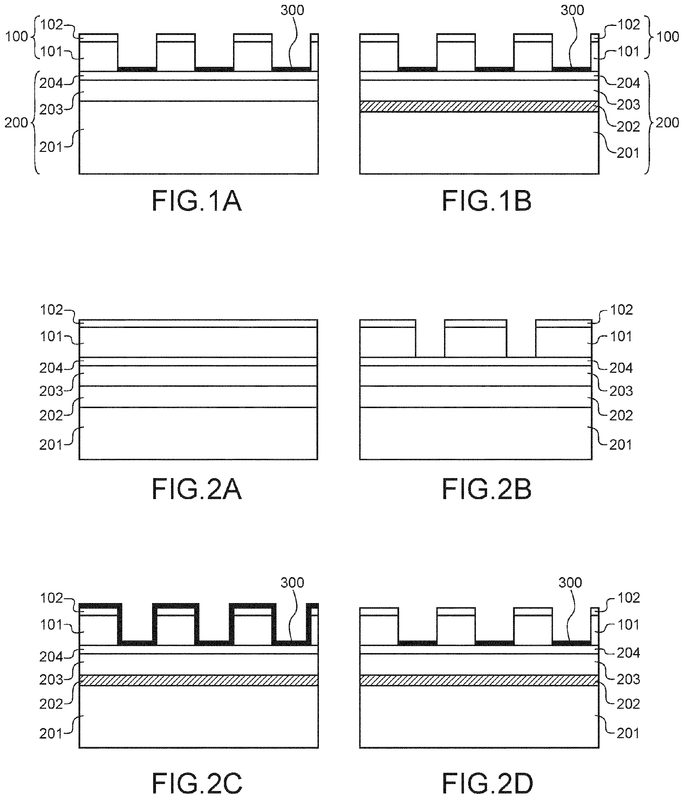

Selon une première variante de réalisation, représentée sur les figures 2A à 2D, un tel dispositif peut être fabriqué selon les étapes suivantes :

- fourniture d'un empilement 200 comprenant, par exemple, un support 201 en saphir ou en silicium, recouvert successivement par une première couche 202 de GaN nid et/ou une deuxième couche 203 de GaN dopée, et une troisième couche 204 électriquement conductrice de GaN fortement dopée n,

- formation d'une couche d'InGaN fortement dopée 101, puis d'une couche d'InGaN non dopée ou faiblement dopée 102,
- structuration, par exemple par photolithographie, de la couche d'InGaN fortement dopée 101 et de la couche d'InGaN non dopée 102 de manière à réaliser des mésas 100,
- formation d'une couche électriquement isolante 300, par exemple en SiO$_2$ ou SiN, entre les mésas 100 de manière à passiver la couche électriquement conductrice 204.

La gravure contrôlée des mésas 100 permet de s'arrêter sur ou dans la couche de GaN n++. Par sur la couche de GaN n++, on entend à l'interface de la couche 204 de GaN n++ et de la couche d'InGaN dopée 101. Autrement dit, la couche de GaN n++ n'est pas complètement gravée de manière à assurer la conduction électrique lors de la porosification électrochimique.

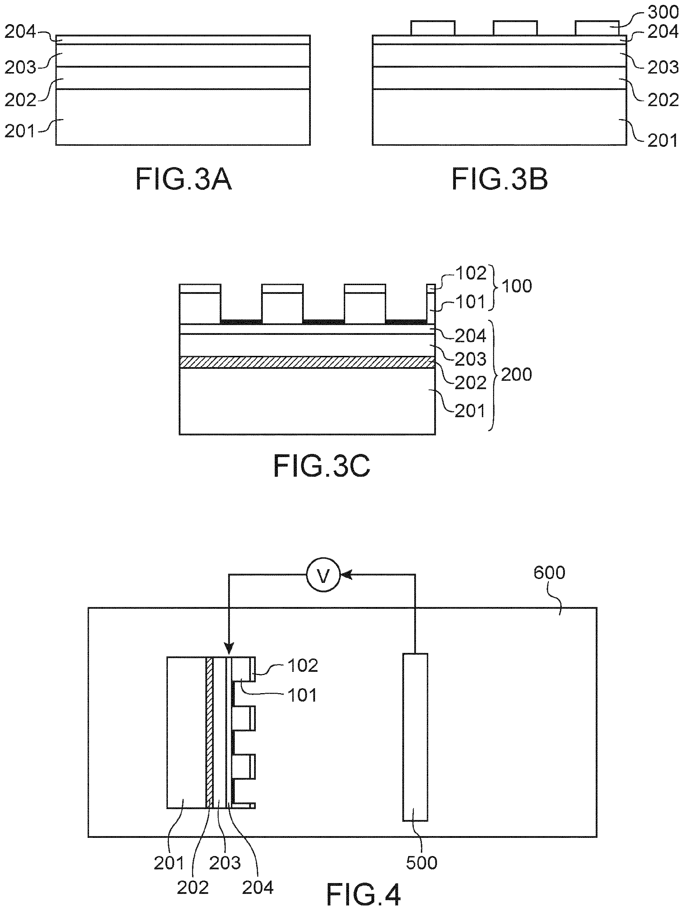

Selon une autre variante de réalisation, représentée sur les figures 3A à 3C, un tel dispositif peut être fabriqué selon les étapes suivantes :

- fourniture d'un empilement 200 comprenant, par exemple, un support 201 en saphir ou en silicium, recouvert successivement par une première couche 202 de GaN nid et/ou une deuxième couche 203 de GaN dopée, et une troisième couche 204 électriquement conductrice de GaN fortement dopée n,
- formation d'une couche électriquement isolante 300, par exemple en SiO$_2$ ou SiN, recouvrant localement la couche électriquement conductrice 204,
- formation des mésas 100 au niveau des zones de la couche électriquement conductrice 204 non recouvertes par la couche électriquement isolante 300, en formant un couche d'InGaN dopée 101 puis une couche d'InGaN non dopée ou faiblement dopée 102.

Selon ce mode de réalisation, la couche électriquement isolante 300 peut être obtenue en déposant une couche continue puis en la gravant. Il est également possible de déposer la couche électriquement isolante 300 à travers un masque. On réalise ensuite la croissance localisée des mésas 100.

Selon ces variantes de réalisation, il est possible de réaliser le dopage de la couche dopée 101 des mésas 100, par exemple, par implantation de silicium (Si(n)) ou par implantation de magnésium (Mg (p)).

Les couches 101 des mésas 100 peuvent avoir des dopages identiques ou différents. L'utilisation de dopages différents permet de jouer sur le taux de porosification des mésas en fonction de leur niveau de dopage initial pour un potentiel appliqué donné. Les mésas sont alors plus ou moins relaxées et plus ou moins aptes à intégrer de l'indium dans les couches. Il est ainsi facile d'obtenir, après reprise d'épitaxie, des pixels de différentes couleurs.

Selon un mode de réalisation avantageux, les mésas d'InGaN de la structure fournie à l'étape a) peuvent être obtenues selon les étapes suivantes :

- déposer une couche d'InGaN dite pleine plaque (c'est-à-dire une couche continue), sur la couche 204 électriquement conductrice de GaN fortement dopée n,
- réaliser localement une étape d'implantation dans la couche d'InGaN pleine plaque de manière à avoir des zones dopées et des zones moins dopées voire non dopées ; par exemple, pour 3 niveaux de dopage de type n, on pourra réaliser 2 lithographies et des masques durs, et implanter du silicium,
- avantageusement, réaliser un recuit thermique dit de guérison,
- déposer une couche d'InGaN non intentionnellement dopée ou faiblement dopée (typiquement avec un résiduel entre 5.10$^{16}$ et 1.10$^{17}$/cm$^3$) pleine plaque sur la couche d'InGaN pleine plaque, par exemple par épitaxie,
- graver la couche d'InGaN pleine plaque à travers la couche d'InGaN non dopée ou faiblement dopée pleine plaque de manière à retirer les zones non implantées, moyennant quoi on forme des mésas d'InGaN 100 comprenant une couche d'InGaN dopée 101 et une couche d'InGaN non dopée ou faiblement dopée 102.

A titre illustratif, il est, par exemple, possible d'utiliser un masque dur, comme un masque de type SiN ou SiO$_2$, pour réaliser l'implantation et des marques d'alignement (par exemple en Al, Ti, TiN) pour faire correspondre les mésas et les zones implantées. Avec deux masques différents, deux zones avec des énergies d'implantation différentes peuvent être réalisées, et donc deux dopages différents en plus du dopage initial de la plaque dopée, par exemple par MOCVD. Les marques d'alignement permettent d'aligner les deux masques pour l'implantation et le masque pour la gravure des mésas.

Le même jeu de masque sera utilisé pour l'implantation et les mésas.

Avantageusement, pour une couche d'InGaN non dopée ou faiblement dopée de faible épaisseur, il est possible de réaliser l'implantation de la couche d'InGaN sous-jacente à travers cette couche.

Pour un dopage de type p, du magnésium peut être implanté.

Avantageusement, les zones dopées ont des dopages différents, moyennant quoi la couche d'InGaN dopée des mésas a des dopages différents. Plus le taux de dopage est élevé, et plus la porosification sera importante à potentiel fixe. La relaxation de la couche d'InGaN dense dépend du taux de porosification des mésas. Ainsi, des quantités différentes d'indium pourront être intégrées lors de la ré-épitaxie d'InGaN sur la couche dense (grâce à la réduction du « compositionnal pulling effect » i.e. du poussage des atomes d'In vers la surface, les empêchant de s'incorporer dans la couche). On obtiendra ainsi, après épitaxie de la structure LED complète, des mésas bleues, vertes et rouges (RGB) sur un même substrat, et en une seule étape de croissance, si l'écart entre les niveaux de relaxation des mésas est suffisant.

Alternativement, dans ces différents modes de réalisation, le dopage par implantation peut être remplacé par un dopage par épitaxie en phase vapeur aux organométalliques (MOCVD), avec comme dopant Si ou Ge notamment. Il est, par exemple, possible de réaliser trois étapes d'épitaxie successives avec masquages successifs pour obtenir 3 niveaux de dopages différents afin de former à la fin du procédé des mésas RGB.

Par la suite, on décrira un dopage de type n, mais il pourrait s'agir d'un dopage de type p.

Lors de l'étape b), le dispositif et une contre-électrode (CE) 500 sont électriquement reliés à un générateur de tension ou de courant (figure 4). Le dispositif joue le rôle d'électrode de travail (WE). Par la suite, on le dénommera générateur de tension, mais il pourrait s'agir d'un générateur de courant permettant d'appliquer un courant entre le dispositif et la contre-électrode.

La contre-électrode 500 est en un matériau électriquement conducteur, comme par exemple un métal tel que le platine.

Lors de l'étape c), les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, $HNO_3$, $NaNO_3$ ou $H_2SO_4$.

Il est possible de réaliser l'étape c) avant l'étape b).

Lors de l'étape d), on applique une tension entre le dispositif et la contre-électrode 500. La tension peut aller de 1 à 100V. Elle est appliquée, par exemple, pendant une durée allant de quelques secondes à plusieurs heures. La porosification est complète lorsqu'il n'y a plus de courant à potentiel imposé. A ce moment-là, toute la structure dopée est porosifiée et la réaction électrochimique s'arrête.

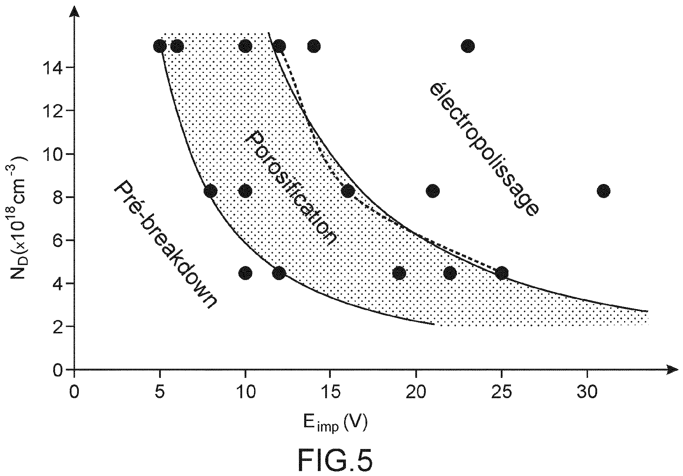

La différence du taux de dopage permet d'avoir une forte sélectivité entre la porosification et l'électropolissage (figure 5). Cet « abaque » permet de définir pour des conditions données, les taux de dopage respectifs pour qu'à potentiel donné, il y ait une sélectivité entre la zone fortement dopée et la zone faiblement dopée

L'étape d'anodisation électrochimique peut être réalisée sous lumière ultra-violette (UV). Le procédé peut également comporter une première anodisation électrochimique sans ajouter de rayonnement ultra-violet et une seconde anodisation électrochimique en ajoutant un rayonnement ultra-violet. Ce mode de réalisation est particulièrement intéressant puisque, par exemple, dans un premier temps, la couche dopée n+ supérieure peut être porosifiée, la porosification s'arrêtant net sur le GaN nid. Puis, dans un deuxième temps, les UV peuvent générer des charges dans le GaN nid et on peut ainsi porosifier du GaN non dopé.

Avantageusement, la porosification a lieu dans tout le volume de la couche d'InGaN dopée 101 des mésas 100.

A l'issue de l'étape de porosification, le taux de porosité de la couche d'InGaN dopée 101 est d'au moins 10%. Il va de préférence de 25% à 50%.

La plus grande dimension (la hauteur) des pores peut varier de quelques nanomètres à quelques micromètres. La plus petite dimension (le diamètre) peut varier de quelques nanomètres à une centaine de nanomètres, en particulier de 30 à 70nm.

La porosification obtenue (taux de porosité et taille des pores) dépend du dopage de la couche d'InGaN dopée 101 des mésas 100 et des paramètres du procédé (tension appliquée, durée, nature et concentration de l'électrolyte, post-traitement chimique ou recuit). La variation de la porosification permet de contrôler le taux d'incorporation / ségrégation. La porosification, et en particulier, la taille des pores, pourra varier ultérieurement, lors de la reprise d'épitaxie en fonction de la température appliquée.

L'étape de porosification permet d'avoir une couche d'InGaN dopée 101 totalement ou partiellement relaxée.

Suite à l'étape de porosification, on réalise une reprise d'épitaxie sur les mésas 100 d'InGaN (étape e), par exemple pour former des LEDs ré-épitaxiées.

La reprise d'épitaxie est réalisée sur la couche d'InGaN non dopée 102 des mésas 100. Comme la couche 102 n'est pas porosifiée lors de l'étape d'anodisation électrochimique, elle permet de réaliser une reprise d'épitaxie sur une couche 2D continue non poreuse, dense. La reprise d'épitaxie est ainsi facilitée et la couche épitaxiée présente une meilleure tenue. La création de défauts liées à la coalescence des pores est évitée.

Différents procédés de croissance peuvent être utilisés pour former une couche épitaxiée 400.

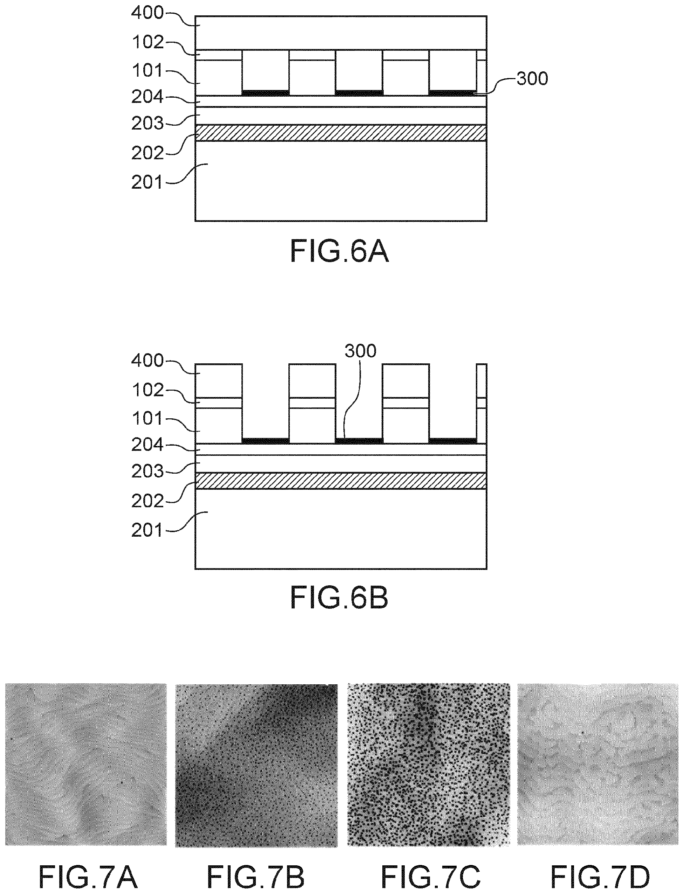

Selon une première variante de réalisation, représentée sur la figure 6A, la reprise de croissance est latérale et une étape de pixellisation ultérieure par gravure est avantageusement réalisée. Il est également possible de passiver les flancs par une couche de faible épaisseur (par exemple 3 nm), de préférence par dépôt de couche atomique (ALD).

Selon une autre variante de réalisation, représentée sur la figure 6B, la reprise de croissance se fait verticalement au-dessus des mésas. Dans cette variante, les pixels correspondent aux mésas sous-jacentes.

La couche épitaxiée 400 est en nitrure d'indium et de gallium.

Avantageusement, une couche de passivation sera déposée sur les flancs des mésas 100 et des LEDs ré-épitaxiées par exemple par dépôt de couche atomique (ALD). La couche de passivation peut être en alumine. La couche de passivation peut avoir une épaisseur de quelques nanomètres, par exemple de 2 à 5nm.

L'empilement réépitaxié d'une LED tout InGaN peut comprendre, par exemple, successivement depuis la couche d'InGaN 102 non intentionnellement dopée :

- une couche d'InGaN dopée n, ayant de préférence la même concentration en In que la couche d'InGaN du substrat,
- une zone active avec un ou plusieurs puits quantiques InGaN/(Ga,In)N émettant dans le rouge ou dans le vert,
- une barrière à électron à base de GaN ou d'AlGaN dopée p
- une couche d'InGaN dopée p, ayant de préférence une concentration en In inférieure ou égale à celle de la couche de n-InGaN,
- une couche d'InGaN dopée p++, ayant de préférence la même concentration en In que la couche de p-InGaN.

Plus particulièrement, une structure LED tout InGaN peut comprendre successivement :

- un substrat InGaN,
- une couche d'InGaN dopée n de 350nm, formée de $15 \times In_{0,03}Ga_{0,97}N$ / GaN (épaisseurs 20nm / 1,8nm),
- des puits quantiques multiples (MQWs), formés de $5 \times In_{0,40}Ga_{0,60}N$ / $In_{0,03}Ga_{0,97}N$ (épaisseurs 2,3nm / 5, 7, 11 nm),
- une couche de $In_{0,03}Ga_{0,97}N$ nid (10nm),
- une couche $Al_{0,1}Ga_{0,9}N$ :Mg (20nm),
- une couche de $In_{0,03}Ga_{0,97}N$ dopée Mg (125nm),
- une couche de $In_{0,03}Ga_{0,97}N$ dopée p+++ (25nm).

Exemples illustratifs et non limitatifs d'un mode de réalisation :

Dans cet exemple, on utilise un empilement 200 comprenant : un support 201 en saphir, une couche 202 de GaN (nid), une couche 203 de GaN dopée (GaN n) et une couche 204 de GaN fortement dopée (GaN n++).

Pour réaliser les mésas 100 d'InGaN, on dépose sur cet empilement 200 une couche d'$In_{0,008}Ga_{0,992}N$ (dopée n : $10^{19}$ at/cm$^3$) 101 de moins de 100nm d'épaisseur. Une couche d'InGaN 102 de même composition mais non dopée, de faible épaisseur (de 2 à 3nm) est déposée afin de faciliter la reprise d'épitaxie ultérieure.

Puis on structure les mésas 100 par des techniques classiques de photolithographie. Les dimensions des mésas 100 obtenues sont de 500 nm à 10$\mu$m. La gravure contrôlée de la couche d'InGaN permet de s'arrêter sur ou dans la couche de GaN n++.

La couche de GaN n++ 204 est ensuite passivée avec une couche 300 en $SiO_2$ ou en SiN par exemple.

L'image AFM de la couche d'InGaN avant porosification est représentée sur la figure 7A.

On réalise ensuite la porosification par anodisation électrochimique des mésas d'InGaN dans une solution électrolytique comprenant de 0,1mol/L à 0,5mol/L d'acide oxalique, par exemple 0,2mol/L. La tension appliquée est de 24V. Les mésas contiennent alors une concentration d'In proche de celle des puits et sont totalement ou presque relaxées. L'image AFM de la couche d'InGaN après porosification est représentée sur la figure 7B.

On réalise ensuite un recuit, par exemple, à 900°C (figure 7C).

Finalement, on réalise une reprise d'épitaxie sur les mésas d'InGaN 100 (figure 7D).

Des caractérisations en photoluminescence (PL) ont été effectuées. Avant porosification, l'émission de l'échantillon InGaN 0,8% est à 356nm. Après la reprise d'épitaxie, l'émission est à 364nm. Des échantillons réalisés avec de l'InGaN 2% montrent la même tendance. Cet écart de PL peut être la signature d'une relaxation des contraintes et/ou de l'intégration de plus d'In.

L'objet de la présente invention est défini par les présentes revendications en annexe.

## RÉFÉRENCES

[1] Even et al., "Enhanced In incorporation in full In-GaN heterostructure grown on relaxed InGaN pseudo-substrate », Appl. Phys. Lett. 110, 262103 (2017).

[2] Jang et al., "Electrical and structural properties of GaN films and GaN/InGaN light-emitting diodes grown on porous GaN templates fabricated by combined electrochemical and photoelectrochemical etching", Journal of Alloys and Compounds 589 (2014) 507-512.

[3] Han et al., US 2017/0237234 A1, "A method for GaN vertical microcavity surface emitting laser (VCSEL)", 17 août 2017.

[4] Wierer et al., US 2009/0140274 A1, "III-nitride light emitting device including porous semiconductor layer", 4 juin 2009.

## Revendications

1. Procédé comprenant les étapes suivantes :

    a) fournir un dispositif comprenant :

       - une structure GaN/InGaN comprenant une couche électriquement conductrice en GaN dopée (204) recouverte localement par des mésas d'InGaN (100), les mésas d'InGaN (100) comprenant successivement une couche d'InGaN dopée (101) et une couche d'InGaN non dopée ou faiblement dopée (102) ayant une épaisseur allant de 0,25 à 3 nm,
- une couche électriquement isolante (300) recouvrant la couche électriquement conductrice en GaN dopée (204) entre les mésas (100),

b) relier électriquement la couche électriquement conductrice en GaN dopée (204) du dispositif et une contre-électrode (500) à un générateur de tension ou de courant,
c) plonger le dispositif et la contre-électrode (500) dans une solution électrolytique,
d) appliquer une tension ou un courant entre la couche électriquement conductrice en GaN dopée (204) et la seconde électrode (500) de manière à porosifier la couche d'InGaN dopée (101) des mésas (100),
e) former une couche d'InGaN par épitaxie sur les mésas d'InGaN (100), moyennant quoi on obtient une couche d'InGaN épitaxiée relaxée (400).

2. Procédé selon la revendication 1, **caractérisé en ce que** la couche électriquement isolante (300) est en SiO$_2$ ou en SiN.

3. Procédé selon l'une des revendications 1 et 2, **caractérisé en ce que** le dispositif fourni à l'étape a) est fabriqué en formant la couche électriquement isolante (300) puis les mésas d'InGaN (100).

4. Procédé selon l'une des revendications 1 et 2, **caractérisé en ce que** le dispositif fourni à l'étape a) est fabriqué en formant les mésas d'InGaN (100) puis la couche électriquement isolante (300).

5. Procédé selon l'une des revendications précédentes, **caractérisé en ce que** la couche électriquement conductrice en GaN dopée (204) recouvre un support (201) en saphir ou en silicium.

6. Procédé selon l'une des revendications précédentes, **caractérisé en ce que** les mésas (100) ont une épaisseur inférieure à 100 nm.

7. Procédé selon l'une quelconque des revendications 1 à 6, **caractérisé en ce que** le procédé comprend une étape au cours de laquelle on réalise une étape de dopage par implantation ou de dopage par épitaxie en phase vapeur aux organométalliques sur les mésas d'InGaN (100).

8. Procédé selon la revendication 7, **caractérisé en ce que** la couche d'InGaN dopée (101) des mésas (100) a des dopages différents.

9. Procédé selon l'une quelconque des revendications 1 à 6, **caractérisé en ce que** les mésas d'InGaN (100) de la structure fournie à l'étape a) sont obtenues selon les étapes suivantes :

- déposer une couche d'InGaN pleine plaque,
- réaliser localement une étape de dopage par implantation ou de dopage par épitaxie en phase vapeur aux organométalliques dans la couche d'InGaN pleine plaque de manière à avoir des zones dopées et des zones non dopées,
- déposer une couche d'InGaN non intentionnellement dopée ou faiblement dopée pleine plaque sur la couche d'InGaN pleine plaque,
- graver la couche d'InGaN pleine plaque à travers la couche d'InGaN non dopée ou faiblement dopée pleine plaque de manière à retirer les zones non dopées, moyennant quoi on forme localement des mésas d'InGaN (100) comprenant une couche d'InGaN dopée (101) et une couche d'InGaN non dopée ou faiblement dopée (102).

10. Procédé selon la revendication 9, **caractérisé en ce que** les zones dopées ont des dopages différents.

11. Structure GaN/InGaN comprenant successivement :

- une couche électriquement conductrice en GaN dopée (204),
- des mésas d'InGaN (100), les mésas d'InGaN (100) comprenant successivement une couche d'InGaN dopée (101) poreuse et une couche d'InGaN non dopée ou faiblement dopée (102) ayant une épaisseur allant de 0,25 nm 3 nm,
- une couche d'InGaN épitaxiée relaxée (400).

**Patentansprüche**

1. Verfahren, die folgenden Schritte umfassend:

a) Bereitstellen einer Vorrichtung, umfassend:

- eine GaN/InGaN-Struktur, die eine elektrisch leitfähige Schicht aus dotiertem GaN (204) umfasst, die lokal von Mesas aus In-GaN (100) bedeckt ist, wobei die Mesas aus InGaN (100) nacheinander eine dotierte Schicht aus InGaN (101) und eine nicht dotierte oder schwach dotierte Schicht aus In-GaN (102) umfassen, die eine Dicke von 0,25 bis 3 nm aufweisen,
- eine elektrisch isolierende Schicht (300), die die elektrisch leitfähige Schicht aus dotiertem GaN (204) zwischen den Mesas (100) bedeckt,

b) elektrisches Verbinden der elektrisch leitfähigen Schicht aus dotiertem GaN (204) der Vorrichtung und einer Gegenelektrode (500) mit einem Spannungs- oder Stromgenerator,

c) Eintauchen der Vorrichtung und der Gegenelektrode (500) in eine Elektrolytlösung,

d) Anlegen einer Spannung oder eines Stroms zwischen der elektrisch leitfähigen Schicht aus dotiertem GaN (204) und der zweiten Elektrode (500), um die Schicht aus dotiertem InGaN (101) der Mesas (100) zu porosieren,

e) Bilden einer Schicht aus InGaN durch Epitaxie auf den Mesas aus InGaN (100), wodurch eine entspannte epitaktische Schicht aus InGaN (400) erhalten wird.

2. Verfahren nach Anspruch 1, **dadurch gekennzeichnet, dass** die elektrisch isolierende Schicht (300) aus $SiO_2$ oder SiN besteht.

3. Verfahren nach einem der Ansprüche 1 und 2, **dadurch gekennzeichnet, dass** die Vorrichtung, die in Schritt a) bereitgestellt wird, durch Bilden der elektrisch isolierenden Schicht (300) und dann der Mesas aus InGaN (100) hergestellt wird.

4. Verfahren nach einem der Ansprüche 1 und 2, **dadurch gekennzeichnet, dass** die Vorrichtung, die in Schritt a) bereitgestellt wird, durch Bilden der Mesas aus InGaN (100) und dann der elektrisch isolierenden Schicht (300) hergestellt wird.

5. Verfahren nach einem der vorhergehenden Ansprüche, **dadurch gekennzeichnet, dass** die elektrisch leitfähige Schicht aus dotiertem GaN (204) einen Träger (201) aus Saphir oder Silizium bedeckt.

6. Verfahren nach einem der vorhergehenden Ansprüche, **dadurch gekennzeichnet, dass** die Mesas (100) eine Dicke von weniger als 100 nm aufweisen.

7. Verfahren nach einem der Ansprüche 1 bis 6, **dadurch gekennzeichnet, dass** das Verfahren einen Schritt umfasst, in dessen Verlauf ein Schritt der Dotierung durch Implantation oder der Dotierung durch metallorganische Gasphasenepitaxie auf den Mesas aus InGaN (100) durchgeführt wird.

8. Verfahren nach Anspruch 7, **dadurch gekennzeichnet, dass** die Schicht aus dotiertem InGaN (101) der Mesas (100) unterschiedliche Dotierungen aufweist.

9. Verfahren nach einem der Ansprüche 1 bis 6, **dadurch gekennzeichnet, dass** die Mesas aus InGaN (100) der Struktur, die in Schritt a) bereitgestellt wird, gemäß den folgenden Schritten erhalten werden:

- Abscheiden einer Vollplatten-Schicht aus InGaN,
- lokales Durchführen eines Schrittes der Dotierung durch Implantation oder der Dotierung durch metallorganische Gasphasenepitaxie in der Vollplatten-Schicht aus InGaN, um dotierte Bereiche und nicht dotierte Bereiche zu erhalten,
- Abscheiden einer Vollplatten-Schicht aus InGaN, die unbeabsichtigt dotiert oder schwach dotiert ist, auf die Vollplatten-Schicht aus InGaN,
- Ätzen der Vollplatten-Schicht aus InGaN durch die nicht dotierte oder schwach dotierte Vollplatten-Schicht aus InGaN hindurch, um die nicht dotierten Bereiche zu entfernen, wodurch lokal Mesas aus InGaN (100) gebildet werden, die eine dotierte Schicht aus InGaN (101) und eine nicht dotierte oder schwach dotierte Schicht aus InGaN (102) umfassen.

10. Verfahren nach Anspruch 9, **dadurch gekennzeichnet, dass** die dotierten Bereiche unterschiedliche Dotierungen aufweisen.

11. GaN/InGaN-Struktur, die nacheinander umfasst:

- eine elektrisch leitfähige Schicht aus dotiertem GaN (204),
- Mesas aus InGaN (100), wobei die Mesas aus InGaN (100) nacheinander eine poröse dotierte Schicht aus InGaN (101) und eine nicht dotierte oder schwach dotierte Schicht aus InGaN (102) umfassen, die eine Dicke von 0,25 nm bis 3 nm aufweisen,
- eine entspannte epitaktische Schicht aus InGaN (400).

**Claims**

1. A method comprising the following steps:

a) providing a device comprising:

- a GaN/InGaN structure comprising an electrically conductive doped GaN layer (204) which is locally covered by InGaN mesas (100), the InGaN mesas (100) successively comprising a doped InGaN layer (101) and an undoped or lightly doped InGaN layer (102) having a thickness ranging from 0.25 to 3 nm,
- an electrically insulating layer (300) covering the electrically conductive doped GaN layer (204) between the mesas (100),

b) electrically connecting the electrically conductive doped GaN layer (204) of the device and a counter electrode (500) to a voltage or current generator,

c) immersing the device and the counter electrode (500) in an electrolytic solution,

d) applying a voltage or a current between the electrically conductive doped GaN layer (204) and the second electrode (500) so as to porosify the doped InGaN layer (101) of the mesas (100),

e) forming an InGaN layer by epitaxy on the In-GaN mesas (100), whereby a relaxed epitaxial InGaN layer (400) is obtained.

2. The method according to claim 1, **characterised in that** the electrically insulating layer (300) is made of $SiO_2$ or SiN.

3. The method according to one of claims 1 and 2, **characterised in that** the device provided in step a) is manufactured by forming the electrically insulating layer (300) then the InGaN mesas (100).

4. The method according to one of claims 1 and 2, **characterised in that** the device provided in step a) is manufactured by forming the InGaN mesas (100) then the electrically insulating layer (300).

5. The method according to one of the preceding claims, **characterised in that** the electrically conductive doped GaN layer (204) covers a sapphire or silicon support (201).

6. The method according to one of the preceding claims, **characterised in that** the mesas (100) have a thickness less than 100 nm.

7. The method according to any one of claims 1 to 6, **characterised in that** the method comprises a step during which a step of implantation doping or of metalorganic vapour-phase epitaxy doping is carried out on the InGaN mesas (100).

8. The method according to claim 7, **characterised in that** the doped InGaN layer (101) of the mesas (100) has different dopings.

9. The method according to any one of claims 1 to 6, **characterised in that** the InGaN mesas (100) of the structure provided in step a) are obtained according to the following steps:

- depositing a full-plate InGaN layer,
- locally carrying out a step of implantation doping or metalorganic vapour-phase epitaxy doping in the full-plate InGaN layer so as to have doped areas and undoped areas,
- depositing an unintentionally doped or weakly doped full-plate InGaN layer onto the full-plate InGaN layer,
- etching the full-plate InGaN layer through the undoped or weakly doped full-plate InGaN layer so as to remove the undoped areas,

whereby InGaN mesas (100) are locally formed comprising a doped InGaN layer (101) and an undoped or weakly doped InGaN layer (102).

10. The method according to claim 9, **characterised in that** the doped areas have different dopings.

11. A GaN/InGaN structure successively comprising:

- an electrically conductive doped GaN layer (204),
- InGaN mesas (100), the InGaN mesas (100) successively comprising a porous doped InGaN layer (101) and an undoped or weakly doped InGaN layer (102), having a thickness ranging from 0.25 nm to 3 nm,
- a relaxed epitaxial InGaN layer (400).

FIG.1A

FIG.1B

FIG.2A

FIG.2B

FIG.2C

FIG.2D

FIG.3A

FIG.3B

FIG.3C

FIG.4

FIG.5

FIG.6A

FIG.6B

FIG.7A        FIG.7B        FIG.7C        FIG.7D

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20170237234 A1, Han
- US 20090140274 A1, Wierer

**Littérature non-brevet citée dans la description**

- **EVEN et al.** Enhanced In incorporation in full InGaN heterostructure grown on relaxed InGaN pseudo-substrate. *Appl. Phys. Lett.,* 2017, vol. 110, 262103

- **JANG et al.** Electrical and structural properties of GaN films and GaN/InGaN light-emitting diodes grown on porous GaN templates fabricated by combined electrochemical and photoelectrochemical etching. *Journal of Alloys and Compounds,* 2014, vol. 589, 507-512